# EUROPEAN PATENT APPLICATION

(11) **EP 2 571 053 A1**
(43) Date of publication of application: **20.03.2013**
(21) Application number: 11181811.8
(22) Date of filing: 19.09.2011
(51) Int. Cl.: H01L 25/07, H01L 23/498, H01L 21/60

(54) **Power semiconductor arrangement and method of forming thereof**

(71) Applicant: ABB Technology AG, 8050 Zürich (CH)
(72) Inventor: Guillon David, 8854 Siebnen (CH); Riedel Gernot, 5406 Baden-Rütihof (DE); Schulz Nicola, 5300 Turgi (CH)
(74) Representative: ABB Patent Attorneys

(57) **Abstract**

The present invention relates to a power semiconductor arrangement (10), comprising a substrate (22), at least one conductor (24) provided on the substrate (22), a power semiconductor device (14) being electrically connected to a conductor (24) and a contact element (16) for contacting the power semiconductor device (14). In order to improve the stress reducing properties and thus to achieve an improved reliability and durability, the contact element (16) comprises a joining area (36) for electrically and mechanically connecting the contact element (16) to a conductor (24), wherein the joining area (36) comprises at least one spatially confined notch (42) at its upper side, and the joining area (36) is mechanically connected to a conductor (24) by means of at least one spatially confined welding connection (44), the at least one spatially confined welding connection (44) being located at the bottom side of the joining area (36) and opposite to the notch (42) and having dimensions being smaller or corresponding compared to the dimensions of the notch (42). The present invention further relates to a method of forming a power semiconductor arrangement (10).

## Description

### Technical Field

The present invention relates to a power semiconductor arrangement comprising a contact element with improved stress reducing properties leading to an improved reliability and durability of the arrangement. The present invention further relates to a method of forming a power semiconductor arrangement allowing reducing the thermo-mechanical stress being introduced into the substrate during the connection process of the contact element to a conductor.

### Background Art

A variety of power semiconductor arrangements, such as power semiconductor modules, are known and used in many different electronic devices. For forming, or manufacturing, respectively, a semiconductor arrangement, different electric components of the latter have to be contacted with each other to provide an interlinked internal structure. Additionally, it is required to provide an external contact to connect one or more electric parts of the semiconductor arrangement to an external contact device. As an example, to achieve an external electrical contact with the semiconductor arrangement, it is widely known to provide a terminal as a contact element and to solder it on top of a metallization of a ceramic substrate.

Known from EP 1 703 554 A2, for example, is a power semiconductor equipment comprising a module with a terminal for connecting semiconductor chips. Such a terminal has an S-shaped form and is soldered to a metallic circuit. From this document, it is known to reduce the thickness of a lower connection part of the S-shaped terminal with respect to another portion of the terminal.

Known from US 2003/0146501 A1 is furthermore a semiconductor device in which one or more power semiconductor elements is/are mounted on a lead frame. Furthermore, an outward guided terminal portion is provided being extended on a base substrate. The lead frame is guided perpendicular to the surface of the base substrate to form the terminal portion. Additionally, the lead frame includes portions each having different thicknesses. With respect to the terminal portion, the thickness is reduced from the bonding surface to the lead frame which is fixedly adhered to the base substrate via an insulating layer.

A major drawback of the known soldering technique is a limited reliability under thermal and mechanical cycling of the soldered connection between terminal and substrate. Therefore, the connection and thus the whole semiconductor module have a limited lifetime only. Furthermore, soldered connections mostly withstand limited operation temperatures only.

It is therefore known to overcome this problem by replacing the soldered connection between one or more contacts of a semiconductor module, e.g. the contact element and the metallization on the substrate, by a welded connection. In any case, the mechanical connection between the contact element and the substrate metallization is significantly stronger than using a soldered joint.

From EP 2 302 674 A1, for example, an electronic circuit module with a terminal is known, the terminal consisting of an electrical contact device for externally contacting the module. The contact device may be welded, for example by ultrasonic welding, to a metallised substrate. In order to weld the contact element to the metallisation, a base element of the contact element, such as a terminal foot, is chosen to be thinner than the terminal body of the contact element.

However, under some circumstances, the connection of the contact element to the substrate may be instable leading to a decreased reliability, and the stress reducing properties might be insufficient, especially when using dimensions being appropriate for power semiconductor applications. This may be due to the fact that especially by welding the contact element to the conductor, thermo-mechanical stress may be introduced into the substrate in such an amount that conchoidal cracks may appear in the ceramics substrate beneath. It is thus problematic to weld a contact element to a conductor, e.g. to a metallisation of a substrate, such as aluminium nitride, being superb for high power applications with respect to its electrical and thermal properties but having a reduced internal strength only.

This effect may be explained in a non-limiting manner with respect to ultrasonic welding as follows. During an ultrasonic welding process, the contact element is heated for example by the friction between the welding tool and the contact element and the conductor, up to a temperature of 400°C, for example. When the ultrasound oscillations of the welding tool stops, the contact element, or its joining area, respectively, is joined to the substrate, or its metallisation, respectively. The contact element immediately cools down due to a heat flux from the contact element to the substrate which in turn is heated. This simultaneous local heating of the substrate and the cooling-down of the joined contact element leads to a bimetal effect. This effect can be further enhanced since the contact element, and the conductor, or the metallisation layer, respectively, have a significantly higher coefficient of thermal expansion than the substrate, which may be the case for most ceramic / metallisation / contact element material combinations. This effect will most likely result in significant mechanical stress in the substrate. In case the mechanical strength of the substrate is below the thermally induced stress, conchoidal cracks will occur in the substrate below the welded contact element. Additionally, the substrate such as the ceramic substrate, beneath the welded contact element is exposed to mechanical stress due to ultrasonic vibrations. These influences may additionally lead to conchoidal cracks to occur in the substrate according to the prior art.

### Summary of invention

It is an object of the present invention to provide a power semiconductor arrangement and a method for forming a power semiconductor arrangement which overcomes at least one of the limitations as set forth above.

It is a further object of the present invention to provide a power semiconductor arrangement and a method for forming a power semiconductor arrangement allowing improved stress reducing properties, reliability properties, durability properties and/or improved manufacturing properties.

This object is achieved by a power semiconductor arrangement according to claim 1. This object is furthermore achieved by a method of forming a power semiconductor arrangement according to claim 9. Preferred embodiments of the present invention are defined in the dependent claims.

The invention relates to a power semiconductor arrangement, comprising a substrate, at least one conductor provided on the substrate, a power semiconductor device being electrically connected to a conductor and a contact element for contacting the power semiconductor device, wherein the contact element comprises a joining area for electrically and mechanically connecting the contact element to a conductor, wherein the joining area comprises at least one spatially confined notch at its upper side, and wherein the joining area is mechanically connected to a conductor by means of at least one spatially confined welding connection, the at least one spatially confined welding connection being located at the bottom side of the joining area and opposite to the notch and having dimensions being smaller or corresponding compared to the dimensions of the notch.

A power semiconductor arrangement according to the invention thus comprises elements which are commonly used for a power semiconductor module, for example, and are generally known. In detail, the power semiconductor arrangement comprises one or a plurality of power semiconductor devices, such as a Metal Oxide Semiconductor Field-Effect Transistor (MOSFET), an Insulated Gate Bipolar Transistor (IGBT), a Bi-Mode Insulated Gate Transistor (BIGT), or a Reverse Conductive IGBT (RC IGBT), for example. The power semiconductor device is electrically connected to a conductor, which may be a metallization being located on a substrate. In order to internally or externally contact the power semiconductor device, a contact element is provided, which is connected to a conductor. In detail, it is electrically connected to the conductor in order to allow contacting the power semiconductor device. Therefore, the contact element is either connected to the conductor being electrically connected to the power semiconductor device, or it is electrically connected to the latter. Additionally, the contact element is mechanically connected to the conductor and thus fixed to the latter.

The electrical as well as the mechanical connection is thereby realized via a joining area of the contact element. The joining area of the contact element shall thereby particularly mean a defined region which is in close contact to the conductor and may preferably lay plane on the latter. Due to the close contact, electrical currents are allowed to flow from the conductor to the contact element, or vice versa. Additionally, the contact element is mechanically fixed to the conductor in this area as described down below.

The joining area comprises at least one spatially confined notch at its upper side and thus at the side being opposite to the conductor. A notch according to the invention shall particularly mean a recess not going through the whole thickness of the contact element but just forming a portion of reduced thickness with respect to a further portion of the joining area. Additionally, the notch does not take the whole dimension of the joining area. Contrary thereto, it is spatially confined and has thus limited and defined dimensions being smaller compared to the dimensions of the joining area.

Additionally, the joining area is mechanically connected to the conductor by means of at least one spatially confined welding connection. As a consequence, the contact element, or joining area, respectively, is not welded to the conductor as a whole, but only via at least one defined welding connection or welding position, respectively. This at least one welding connection is thus spatially confined. It is located at the bottom side of the joining area and opposite to the notch. This shall mean that the welding connection lies on the opposite side of the joining area with respect to the notch, but adjacent to the latter and thus in the corresponding position.

From the description above it becomes apparent that the welding connection might be realized by introducing a welding force into the joining area strictly at the region of the notch, which will be described in more detail below. Due to the fact that at least one spatially confined welding connection is provided lying opposite to at least one notch, the manufacturing process of such power semiconductor arrangements is significantly improved with respect to thermo-mechanical stress and thus with respect to reliability and durability of the so formed arrangements. In detail, by using a contact element having the above defined joining area, the latter may be welded to the conductor with a significant decrease of stress being exerted to the respective components. As a consequence, by welding the contact element to the conductor at the notch of the joining area, cracks such as conchoidal cracks, may significantly be reduced or completely be avoided.

This leads to the welding connection having dimensions being smaller or corresponding compared to the dimensions of the notch. This shall mean that the at least one welding connection has maximum dimensions being corresponding to the dimensions of the notch. The welding connection is thus smaller compared to the notch or has a corresponding size. Corresponding dimensions shall thereby mean that the dimensions of the at least one welding connection are equal or marginally larger than the notch. In detail, the welding connections may be larger compared to the notch to an amount being twice the thickness of the contact element at the notch. This might be due to the fact that, for ultrasonic welding, for example, ultrasonic waves might be guided not strictly perpendicular with respect to the surface of the notch, but they may be guided to a place lying next to the notch. However, such welding connections have substantially the same size compared to the notch and have thus a corresponding size.

The dimension as well as the number of the welding connections as well as of the notches may thereby be chosen in dependence of the required properties, such as the joining strength and the current carrying capability.

The present invention is based on the finding that the induced thermo-mechanical stress is higher for a larger volume of the joining area since more heat is stored in the latter, compared to a smaller volume of the joining area. In detail, by providing a contact element with at least one spatially confined notch at its upper side, the welding energy may be introduced into the contact element exclusively at the notch. At the regions of the notch, however, the contact element, or its joining area, respectively, has a reduced thickness and hence a reduced volume. Consequently, the amount of energy and thus heat being stored in the joining area is minimized in this region and thus the heat flowing to the substrate and the conductor is further minimized.

Due to the fact that the at least one notch is provided at the upper side of the joining area, the bottom side is not influenced in an undesired manner because of which the stability of the connection is not deteriorated.

According to the invention it thus becomes possible to provide a power semiconductor arrangement with a contact element being welded on conductors located on mechanically weak or brittle substrates. Using aluminium nitride, for example, as rather weak substrate, may provide a superior performance of the power semiconductor arrangement as this substrate material exhibits superior properties compared to commonly applied substrate materials used in combination with welding processes. These common substrates, such as Si₃N₄ or Al₂O₃ are usable for welding processes but, however, have only limited properties for use in high-voltage power electronic modules being able to work with voltages of ≥ 3 kV.

Additionally, due to the fact that a smaller volume has to be heated for welding purposes, the amount of energy being required for welding the contact element to the metallization may be reduced. Consequently, the impact of ultrasonic waves to the substrate may as well be reduced.

A power semiconductor arrangement according to the invention is however well suitable for high power purposes due to the fact that not the whole joining area has a low thickness, but only the region at the at least one notch has a reduced thickness. In other words, the remaining parts of the joining area, or the contact element, respectively, have a suitable thickness for achieving a low electrical resistance and a high mechanical strength being appropriate for high power applications.

Apart from that, due to the fact that at least one spatially confined welding connection is provided and thus the thermo-mechanical stress being introduced into the substrate is significantly reduced, the connection of the contact element to the conductor has an especially high durability as well as reliability.

According to an embodiment the contact element is at least partly "L"-shaped and comprises a first arm being welded to the conductor, and a second arm for electrically interconnecting the contact element, and wherein the joining area is formed by the first arm.

According to the invention, an at least partly "L"-shaped contact element shall mean that at least the bottom part, where the contact element is connected to the conductor on the substrate, or its metallization, respectively, is "L"-shaped. The first arm may thereby easily be used to fix the contact element to the conductor e.g. by exercising a pressing force on the latter in a well defined manner, thereby applying ultrasonic energy to weld the first arm, or the contact element, respectively, to the conductor. However, the present invention is not limited to an ultrasonic welding of the contact element to the conductor. Other welding techniques, such as micro-resistance welding, are furthermore possible. Due to the "L"-shaped form of the contact element, the second arm is located spaced apart from the substrate because of which it may easily be interconnected with an external contact device, for example. At this side of the second arm which is spaced apart from the first arm, different structures of the contact element may follow.

Furthermore, an L"-shaped form thereby shall mean a design in which the first and second arms are arranged substantially rectangular with respect to each other. However, the contact element may deviate from the rectangular shape if the first arm lays substantially plane on the substrate and the second arm proceeds such, that its end is spaced apart from the plane of the substrate, so that an interconnection may easily be made.

The first arm and the second arm may thereby be formed in one piece, the piece being bended between the two arms forming the latter. Alternatively, it is possible to form the first arm and the second arm out of two pieces, the latter being connected at their ends.

Due to the fact that the contact element is at least partly "L" shaped, a big joining area between the contact element, or its first arm, respectively, and the conductor on the substrate may be provided. This enables a secure and reliable connection leading to a high durability of a semiconductor module equipped with a contact element according to the invention. This contact area is furthermore not deteriorated according to the present invention due to the fact that the at least one notch may be solely formed at the upper side of the joining area.

Additionally, it is possible to attach the contact element to a substrate conductor substantially without limitations with respect to the applied connection technique. It is well possible to use ultrasonic welding procedures, for example by using a sonotrode. Thereby, a force may be applied to the upper side of the first arm at the region of the notch thereby enabling a strong joint to be formed between the contact element and the substrate conductor. However, other welding techniques are furthermore possible in an easy manner.

In a further embodiment the at least one notch has a round or a rounded cross section. A round cross section in the sense of the present invention may particularly mean an oval cross section, an elliptic cross section or a circular cross section. A rounded cross section may include a rectangular cross section or any other form, in which respective corners are rounded. When having a round or rounded cross section, a round or rounded welding area or welding connection, respectively, is provided instead of a strictly rectangular one, for example, especially in case a round welding tool was used. A round or rounded welding connection thereby imposes less stress to the substrate. This is due to the fact that no corners are present at which the stress would achieve a maximum. Rounded corners shall thereby particularly mean the corners being visible at a top view of the notch.

In a further embodiment the notch has rounded edges. This feature prevents, during the formation of the power semiconductor arrangement, the welding tool from touching inner walls of the notch which decreases the risks of cracks in the substrate to occur. Contrary thereto, if the welding tool gets too close to the edge, or the inner wall, respectively, it will experience a guiding force towards the centre and thus way from the inner wall of the notch. For example, the rounded edges may have a radius of > 0.5 mm. Edges in the sense of the present invention shall particularly mean the contact of the inner wall and the bottom of the notch, being visible at a sectional view through the notch.

In a further embodiment the at least one notch is completely surrounded by a framing of the joining area, the framing particularly having a thickness of ≥ 1 mm, for example of ≥ 2 mm, and particularly having a width of ≥ 0.5 mm. In other words, the notch is only opened to the upper side of the joining area and it is spaced apart from the end of the joining area in a distance of ≥ 0.5 mm. By providing such a framing, the mechanical stability of the contact element is maintained on a high level, leading to an especially high reliability as well as durability. Apart from that, the electrical resistance of the contact element is kept low enough in order to allow the power semiconductor arrangement according to the invention to be suitable for high power applications, especially for those working with high voltages of more than 3.3 kV.

In a further embodiment a plurality of spatially confined welding connections is provided opposite to one notch. According to this embodiment, the power semiconductor arrangement is especially easy to prepare. In detail, the contact element, or its joining area, respectively, may comprise one notch having rather large dimensions, such as 5 x 5 mm², or even larger. Opposite and adjacent this rather large notch, a plurality of welding connections may be provided. The size and number of welding connections may thereby be easily chosen in dependence of the desired joining strength, for example.

In a further embodiment the contact element at the notch has a thickness in the range of < 1 mm, in particular ≤ 0.5 mm. In this embodiment, the contact element has a thickness at the region of the notch, which is especially well suited for welding purposes, wherein only a limited amount of heat flows into the substrate. Consequently, by manufacturing a power semiconductor arrangement according to this embodiment, the thermo-mechanical strength being guided into the substrate is especially low leading to an arrangement with especially improved reliability and durability properties. Apart from that, a contact element having this thickness at its notch may very fast achieve temperatures being suitable for the welding process. Consequently, the application duration of ultrasonic waves, for example, impinging on the contact element but also on the substrate may significantly be reduced even in case the joining area as such has dimensions being used for high power applications. This additionally reduces stress being introduced into the substrate.

In a further embodiment, the at least one notch has dimensions in the range of ≥ 2.0 mm to ≤ 10 mm. These dimensions are sufficiently large in order to allow appropriate welding connections to be formed. Additionally, these dimensions do not deteriorate the stability of the contact element as such, leading to a further improved reliability as well as durability. The term dimension in the sense of the present invention is thereby particularly understood as the maximum expansion independently of the exact shape of the notch.

The present invention further relates to a method of forming a power semiconductor arrangement, the method comprising the steps of:
- placing a joining area of a contact element onto a conductor, the conductor being located on a substrate and the joining area comprising at least one spatially confined notch at its upper side, and
- welding the contact element to the conductor by applying a welding force to the contact element solely at the notch.

The method according to the present invention thus deals with the manufacturing of a semiconductor arrangement according to the invention. Such a method may comprise steps, such as providing a substrate and providing a conductor thereon, which are known in the art and are not crucial for the effect of the present invention. They are thus not described here in detail. The essential step of the method according to the invention is to fix the contact element to the conductor in a defined way.

In detail, a contact element is placed onto a conductor, the conductor being located on a substrate. The contact element thereby comprises a joining area for electrically and mechanically connecting the contact element to the conductor. Consequently, the joining area of the contact element is placed onto the conductor. According to the invention, the joining area comprises at least one spatially confined notch at its upper side. By applying a welding force to the contact element solely at the notch, i.e. at the position of the notch, the contact element may then be welded to the conductor, thereby forming at least one spatially confined welding connection. The remaining joining area is not connected to the conductor but may act a mechanical support. The welding tool, for example the sonotrode, may thereby be smaller than the notch in order to perform the welding process like described above. This reduces the risks of cracks to be formed in the substrate. In detail, due to the fact that the welding force is applied to the contact element solely at the notch, the volume of the contact element being heated is reduced due to the reduced thickness of the contact element in this region. Consequently, the energy flowing into the substrate and thus the thermo-mechanical stress is minimized.

As a result, the method according to the invention not only allows forming a power semiconductor arrangement using conventional substrate materials in combination with a welding process more reliable, but also allows using more weak substrate materials, such as aluminium nitride in combination with welding processes in an easy and save manner. Apart from that, it is referred to the advantages described with respect to the power semiconductor arrangement according to the invention.

In an embodiment the contact element is welded to the conductor by ultrasonic welding, laser welding, or micro resistive welding. These kind of welding techniques are easy and well controllable to perform and allow a defined welding result. Apart from that, these techniques are applicable for large scale production lines.

### Brief description of drawings

Additional features, characteristics and advantages of the subject-matter of the invention are disclosed in the subclaims, the figures and the following description of the respective figures and examples, which -in an exemplary fashion- show embodiments and examples of a contact element according to the invention.

In the figures:

Figure 1 shows a schematic sectional view of a power semiconductor arrangement according to the invention;

Figure 2 shows a schematic view of a part of a contact element according to an embodiment of the present invention from above;

Figure 3 shows a schematic cross sectional view of the embodiment of figure 2;

Figure 4 shows a schematic top view of a joining area according to a further embodiment of the present invention; and

Figure 5 shows a schematic top view of a joining area according to a further embodiment of the present invention.

### Description of embodiments

In the following, the invention is described in detail with respect to different embodiments in which the same or comparable elements are referred to with the same reference signs.

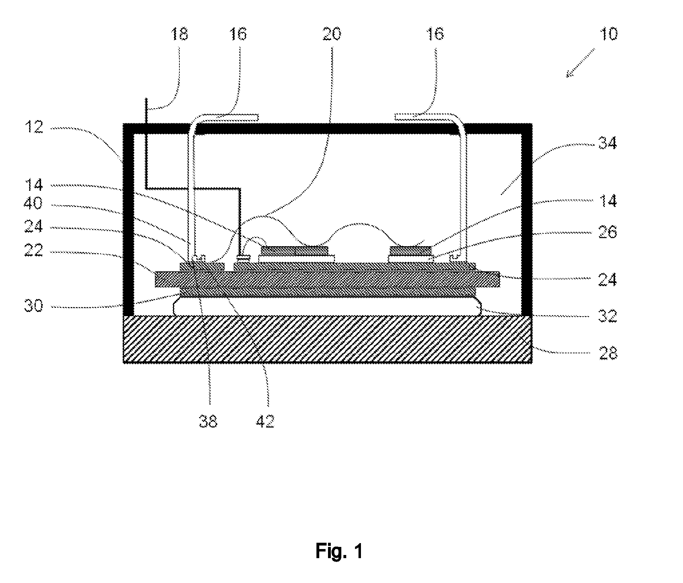

In figure 1, a power semiconductor arrangement 10 according to the invention is schematically shown. The power semiconductor arrangement 10 may form or be part of a power semiconductor module, for example. In detail, the internal structure of said semiconductor arrangement 10 is described. The semiconductor arrangement 10 comprises a housing 12 in which at least one power semiconductor device 14 is arranged. The power semiconductor device 14 may in a preferred example be a Metal Oxide Semiconductor Field-Effect Transistor (MOSFET), an Insulated Gate Bipolar Transistor (IGBT), a Bi-Mode Insulated Gate Transistor (BIGT), or a Reverse Conductive IGBT (RC IGBT), or the like. According to figure 1, a diode and an IGBT are provided as power semiconductor devices 14. The power semiconductor device 14 or the plurality of semiconductor devices 14 are connectable via contact terminals, or contact elements 16, respectively, and preferably via an auxiliary terminal 18. In detail, the contact elements 16 may serve as en emitter terminal and as a collector terminal, whereas the auxiliary terminal 18 may serve as a gate. The power semiconductor device 14 or the plurality of semiconductor devices 14 is preferably bonded by aluminium bond wires 20.

The power semiconductor device 14 may further be arranged on a substrate 22, or wafer, respectively, which may be formed of a ceramic insulator, in particular of an aluminium nitride ceramic insulator, and which may have a thickness in the range of ≥ 0.3 mm to ≤ 1.0 mm. In detail, the contact elements 16 as well as the auxiliary terminal 18 are connected to a conductor 24, such as a metallization, provided on the substrate 22, in particular a copper metallization. The conductor 24, or the metallisation, may be formed as a structure being appropriate for the desired application and may have a thickness in the range of ≥ 0.2 mm to ≤ 0.5 mm, e.g. 0.3 mm. However, thicknesses in the range of ≥ 0.5 mm may be possible as well. Electrically connected to the conductor 24 via a solder 26, for example, is in turn the power semiconductor device 14. Additionally, the substrate 22 is connected at its bottom side to a base plate 28 via a further conductor 30, in particular a copper metallization, and via a solder 32. The remaining volume inside the housing 12 is filled e.g. with a silicon gel 34. The power semiconductor devices 14 are preferably capable of blocking at least 100 V and carrying currents of at least 5 A.

In order to connect the power semiconductor arrangement 10 to an electrical circuit, the contact elements 16 can be guided to the outside of the housing 12 of the power semiconductor arrangement 10 as shown in figure 1. In an alternative embodiment, not shown in the figures, the contact element 16 is electrically connected to a power terminal of the power semiconductor arrangement 10 for connecting the power semiconductor arrangement 10 to an electrical circuit.

Like stated above, the contact element 16 as well as the conductor 24 may be formed of copper, for example. Copper has a higher coefficient of thermal expansion (CTE) (α=16E⁻⁶ /K) compared to the most ceramic substrates (e.g. AIN α = 4.7E⁻⁶ /K). Due to the mismatch in the coefficient of thermal expansion between the contact element 16 or the conductor 24 and the ceramic substrate 12, thermo-mechanical stress is induced when changing the module temperature, i.e. when cycling occurs or especially when the contact element 16 is welded to the conductor 24. Stress appears especially at the conductor-substrate interface being a major danger for substrate cracking.

In order to reduce or completely avoid this danger, the contact element 16 comprises a special joining area 36 for electrically and mechanically connecting the contact element 16 to the conductor 24. This may be seen in figure 1 and in particular in the following figures.

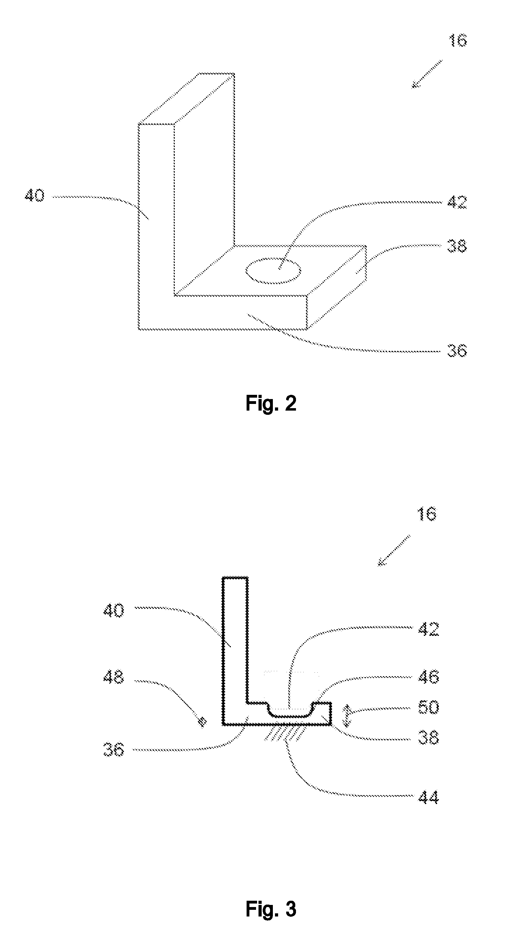

According to figure 2, the contact element 16 is at least partly "L"-shaped and comprises a first arm 38 being welded to the conductor 24, and a second arm 40 for electrically interconnecting the contact element 16. Furthermore, the joining area 36 may preferably be formed by the first arm 38.

With respect to the joining area 36, the latter comprises at least one spatially confined notch 42 at its upper side. The spatially confined notch 42 according to figure 2 has a round cross section. In detail, it has a circular cross section. With respect to its dimensions, the notch 42 may have a dimension in the range of ≥ 2.0 mm to ≤ 10 mm. Additionally, the joining area 36 is mechanically connected to a conductor 24 by means of at least one spatially confined welding connection 44. In detail, the contact element 16 is welded to the conductor 24, for example by ultrasonic welding, laser welding, or micro resistive welding.

With respect to a welding connection, the latter may sustain temperatures of 200°C or more and a power semiconductor arrangement 10 may be manufactured according to this embodiment without the requirement of consumables like solder or bond wires leading to advantages with respect to the environmental point of view.

By welding the contact element 16 to the conductor 24, furthermore a highly conductive connection is formed. This makes the power semiconductor arrangement 10 according to the invention being particularly suitable for power applications in which high amounts of electric currents have to be conducted through this connection.

According to the invention, the contact element 16 is configured for carrying currents of at least 10A. It is thus designed as a terminal for externally contacting the conductor 24, or the power semiconductor device 14, respectively, to an external contacting device. It may thus be part of the power current path of a power semiconductor module. In order to be configured for carrying currents of at least 10A, the contact element 16 may particularly be formed in defined dimensions. Exemplary dimensions which might be used for a contact element 16 to carrying currents of at least 10A may comprise a thickness of > 1 mm, for example ≥ 1 mm to ≤ 2 mm and a width of ≥ 5 mm, for example up to ≤ 10mm, at least at the joining area 36.

Referring back to the joining area 36, figure 3 shows a joining area 36 with one spatially confined notch 42 at the upper side. The notch 42 according to figure 3 has rounded edges 46 in order to further reduce the thermo-mechanical stress being introduced into the substrate at the welding process. It can furthermore be seen that the at least one spatially confined welding connection 44 is located at the bottom side of the joining area 36 and opposite to the notch 42. It has dimensions being smaller or corresponding compared to the dimensions of the notch 42. Additionally, the contact element 16, or the joining area 36, respectively, has a thickness at the notch 42 in a range of < 1 mm, in particular ≤ 0.5 mm. This is visualized by the arrow 48. With respect to the joining area 36 next to the notch 42, the latter may have a thickness in the range of > 1 mm, in particular ≥ 2mm. This is visualized by the arrow 50.

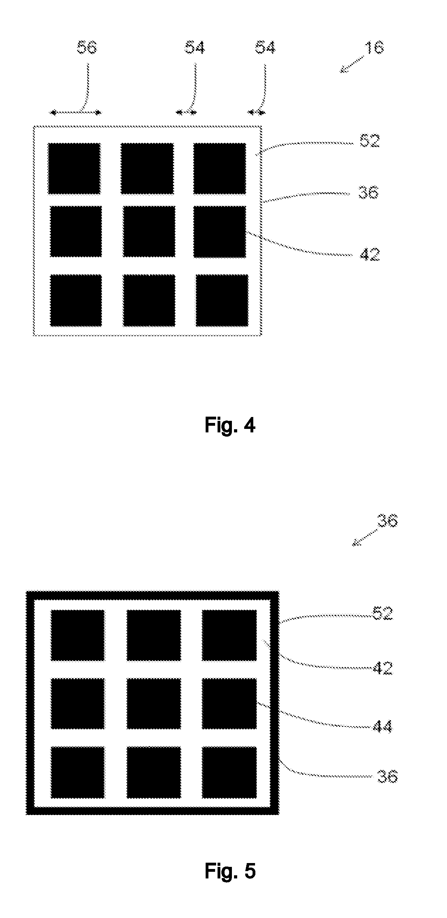

Like may be seen in figure 4, a plurality of spatially confined notches 42 may be provided. Independently of the number of notches 42, they may be completely surrounded by a framing 52 of the joining area 36. The framing 52 particularly has a width of ≥ 0.5 mm like can be seen by the arrows 54, and furthermore may have a thickness in the range of ≥ 1 mm, particularly ≥ 2 mm. The arrow 56 shows the width of the notch 42, which may lie in the range of range of ≥ 2.0 mm to ≤ 10 mm. The above described dimensions may be preferred independently of the shape of the notch 42. According to figure 4, the welding connections 44, not shown as such, are located opposite the notches 42 and have corresponding dimensions.

Figure 5 shows a further embodiment of the present invention. According to figure 5, a plurality of spatially confined welding connections 44 is provided opposite to one notch 42. In detail, one big notch 42 is provided, opposite of which the joining area 36 is welded to the conductor 24 at a plurality of welding connections 44. For example, the joining area 36, or the first arm 38, respectively, may have a dimension of 5 mm x 5 mm, wherein a notch having dimensions of 4 mm x 4 mm may be realized. The welding connections may have dimensions like described above with regard to figure 4 concerning the notches 42. It is obvious that the notch 42 as well as the welding connections 44 are shown in one side for explanation purposes only. From the above it becomes clear that the notch 42 and the welding connections 44 are located on opposite sides of the joining area 36.

In order to form, or manufacture, a power semiconductor arrangement according to the invention, the respective method comprises the steps of: placing a joining area of a contact element onto a conductor, the conductor being located on a substrate and the joining area comprising at least one spatially confined notch at its upper side, and welding the contact element to the conductor by applying a welding force to the contact element solely at the notch.

While the invention has been illustrated and described in detail in the drawings and foregoing description, such illustration and description are to be considered illustrative or exemplary and not restrictive, the invention is not limited to the disclosed embodiments. Other variations to the disclosed embodiments can be understood and effected by those skilled in the art in practicing the claimed invention, from a study of the drawings, the disclosure, and the appended claims. In the claims, the word "comprising" does not exclude other elements or steps, and the indefinite article "a" or "an" does not exclude a plurality. The mere fact that certain measures are recited in mutually different dependent claims does not indicate that a combination of these measures cannot be used to advantage. Any reference signs in the claims should not be construed as limiting the scope.

### Reference Signs List

- 10: power semiconductor arrangement
- 12: housing
- 14: power semiconductor device
- 16: contact element
- 18: auxiliary terminal
- 20: aluminium bond wire
- 22: substrate
- 24: conductor
- 26: solder
- 28: base plate
- 30: conductor
- 32: solder
- 34: silicon gel
- 36: joining area
- 38: first arm
- 40: second arm
- 42: notch
- 44: welding connection
- 46: edge
- 48: arrow
- 50: arrow
- 52: framing
- 54: arrow
- 56: arrow

## Claims

1. Power semiconductor arrangement, comprising a substrate (22), at least one conductor (24) provided on the substrate (22), a power semiconductor device (14) being electrically connected to a conductor (24) and a contact element (16) for contacting the power semiconductor device (14), wherein the contact element (16) comprises a joining area (36) for electrically and mechanically connecting the contact element (16) to a conductor (24), wherein the joining area (36) comprises at least one spatially confined notch (42) at its upper side, and wherein the joining area (36) is mechanically connected to a conductor (24) by means of at least one spatially confined welding connection (44), the at least one spatially confined welding connection (44) being located at the bottom side of the joining area (36) and opposite to the notch (42) and having dimensions being smaller or corresponding compared to the dimensions of the notch (42).

2. Power semiconductor arrangement according to claim 1, wherein the contact element (16) is at least partly "L"-shaped and comprises a first arm (38) being welded to the conductor (24), and a second arm (40) for electrically interconnecting the contact element (18), and wherein the joining area (36) is formed by the first arm (38).

3. Power semiconductor arrangement according to claim 1 or 2, wherein the at least one notch (42) has a round or a rounded cross section.

4. Power semiconductor arrangement according to any of the preceding claims, wherein the notch (42) has rounded edges (46).

5. Power semiconductor arrangement according to any of the preceding claims, wherein the at least one notch (42) is completely surrounded by a framing (52) of the joining area (36), the framing (52) particularly having a thickness of ≥ 1 mm, for example of ≥ 2 mm, and particularly having a width of ≥ 0.5 mm.

6. Power semiconductor arrangement according to any of the preceding claims, wherein a plurality of spatially confined welding connections (44) is provided opposite to one notch (42).

7. Power semiconductor arrangement according to any of the preceding claims, wherein the contact element (16) at the notch (42) has a thickness in the range of < 1 mm, in particular ≤ 0.5 mm.

8. Power semiconductor arrangement according to any of the preceding claims, wherein the at least one notch (42) has dimensions in the range of ≥ 2.0 mm to ≤ 10 mm.

9. Method of forming a power semiconductor arrangement (10), the method comprising the steps of:
- placing a joining area (36) of a contact element (16) onto a conductor (24), the conductor (24) being located on a substrate (22) and the joining area (36) comprising at least one spatially confined notch (42) at its upper side, and
- welding the contact element (16) to the conductor (24) by applying a welding force to the contact element (16) solely at the notch (42).

10. Method of forming a power semiconductor arrangement (10) according to claim 9, wherein the contact element (16) is welded to the conductor (24) by ultrasonic welding, laser welding, or micro resistive welding.
